Europäisches Patentamt

European Patent Office

Office européen des brevets

(19)

(11) Numéro de publication : **0 452 212 A1**

## (12) DEMANDE DE BREVET EUROPEEN

(21) Numéro de dépôt : **91400955.0**

(22) Date de dépôt : **09.04.91**

(51) Int. Cl.$^5$ : **H03J 7/02**

(30) Priorité : **12.04.90 FR 9004748**

(43) Date de publication de la demande :
**16.10.91 Bulletin 91/42**

(84) Etats contractants désignés :
**AT BE CH DE DK ES FR GB GR IT LI LU NL SE**

(71) Demandeur : **TEKELEC AIRTRONIC**
**Cité des Bruyères, Rue Carles Vernet**
**F-93310 Sèvres (FR)**

(72) Inventeur : **Forterre, Gérard, Ernest, Emile**
**3 Rue Pasteur Martin Luther King**
**F-92700 Colombes (FR)**
Inventeur : **Guichaoua Claude, Michel, Pierre,**
**Marie**
**6 Cour St Eloi**
**F-75012 Paris (FR)**

(74) Mandataire : **Berger, Helmut et al**
**Cabinet Z. WEINSTEIN 20, avenue de**
**Friedland**
**F-75008 Paris (FR)**

(54) **Procédé pour accorder au moins un filtre à fréquence variable d'un arrangement de filtre sur une nouvelle fréquence sélectionnée et système pour la mise en oeuvre de ce procédé.**

(57) L'invention concerne un procédé pour accorder au moins un filtre à fréquence variable d'un arrangement de filtre sur une nouvelle fréquence sélectionnée.

Un tel filtre comporte un organe de variation de fréquence qui est mobile sous l'effet d'un moteur (M1-M5. Le procédé est caractérisé en ce que l'on applique au filtre (F1 - F5) un signal de la fréquence sélectionnée et, pendant une première phase, on mesure l'amplitude du signal de sortie du filtre et positionne l'organe de variation de fréquence dans la position où l'amplitude du signal est maximale, et établit pendant une seconde phase, à partir de cette position d'amplitude maximale, par mesure de l'amplitude du signal de sortie, la position centrale de l'organe pour laquelle la fréquence sélectionnée constitue la fréquence par rapport à laquelle la courbe caractéristique du filtre (F1 - F5) est sensiblement symétrique.

L'invention est utilisable pour des systèmes comportant des filtres à résonateur diélectrique.

EP 0 452 212 A1

L'invention concerne un procédé pour accorder au moins un filtre à fréquence variable d'un arrangement de filtre sur une nouvelle fréquence sélectionnée, le filtre comportant un organe de variation de fréquence qui est mobile sous l'effet d'une force d'entraînement externe, selon lequel on déplace l'organe de variation de fréquence jusqu'à ce qu'il se trouve dans une position représentative de l'accord du filtre sur la nouvelle fréquence sélectionnée, et un système pour la mise en oeuvre de ce procédé.

Jusqu'à présent il n'a pas été possible de proposer un procédé et un système du type susmentionné qui permettent l'accord sur une nouvelle fréquence sélectionnée, rapidement, avec une grande précision tout en assurant une excellente stabilité eu égard à des dérives de fréquence en fonction de la température ambiante.

La présente invention a pour but de proposer un procédé et un système qui permettent de satisfaire à ces exigences.

Pour atteindre ce but, le procédé selon l'invention est caractérisé en ce que l'on applique au filtre un signal de la fréquence sélectionnée et, pendant une première phase, on mesure l'amplitude du signal de sortie du filtre et positionne l'organe de variation de fréquence dans la position où l'amplitude du signal est maximale et établit pendant une seconde phase, à partir de cette position d'amplitude maximale par mesure de l'amplitude du signal de fréquence sélectionnée la position centrale de l'organe pour laquelle la fréquence sélectionnée constitue la fréquence par rapport à laquelle la courbe caractéristique du filtre est sensiblement symétrique.

Selon une caractéristique avantageuse de l'invention, pendant la seconde phase précitée, on déplace l'organe mobile à partir de la fréquence d'amplitude maximale dans l'un et l'autre sens jusqu'à ce que l'amplitude du signal mesurée ait chaque fois la même valeur prédéterminée et calcule à partir de ces courses de l'organe mobile, la position centrale précitée.

Selon une autre caractéristique avantageuse de l'invention, on utilise un moteur pas-à-pas pour l'entraînement de l'organe mobile et un ordinateur pour la commande du moteur.

Selon une autre caractéristique de l'invention, on prévoit une correction de la position de cet organe en fonction de la variation de la température ambiante à partir de données préalablement stockées spécifiant le nombre de pas de correction du moteur et le sens de sa rotation en fonction de la température.

Selon encore une autre caractéristique avantageuse de l'invention, on établit pendant des arrêts du fonctionnement du filtre, avantageusement par un processus de balayage de la gamme des fréquences sélectionnables les valeurs des pas du moteur en fonction de la fréquence à partir d'une position de référence du moteur, telle que par exemple la position zéro ou initiale, et effectue au moins pendant la période de fonctionnement suivante les accords sur des fréquences sélectionnées nouvelles à partir des valeurs établies précitées.

Le système pour la mise en oeuvre du procédé selon l'invention est caractérisé en ce qu'il comprend un moteur avantageusement pas-à-pas monté dans une boucle de réglage adaptée pour positionner l'organe de variation de fréquence en fonction d'une valeur prédéterminée de la fréquence sélectionnée du filtre, telle que l'amplitude de celle-ci.

Selon une caractéristique avantageuse, le système comporte un ordinateur monté dans la boucle de réglage qui est programmé pour piloter le moteur à l'aide d'un algorithme utilisant un ensemble de données contenues dans des mémoires et de données détectées à l'interface de l'ordinateur telles que des valeurs d'amplitude mesurées et des valeurs de température ambiante du système.

L'invention sera mieux comprise et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention et dont la figure unique est un schéma bloc d'un système selon l'invention comportant une pluralité de filtres à fréquence variable, destinés à être accordés selon le procédé proposé par l'invention.

La figure unique montre un arrangement de cinq filtres à fréquence variable F1 à F5 et un système permettant d'accorder ces filtres chacun sur une nouvelle fréquence sélectionnée. Ces filtres sont du type comprenant un organe de variation de fréquence et d'accord sur une nouvelle fréquence, qui est mobile sous l'effet d'un dispositif d'entraînement tel qu'un moteur. A titre d'exemple, on pourrait utiliser des filtres à résonateur diélectrique dont l'organe de variation de fréquence pourrait être réalisé sous forme d'un plongeur pénétrant plus ou moins profondément dans une cavité centrale ménagée dans le corps résonateur. Le plongeur pourrait être axialement déplaçable par le moteur, avantageusement un moteur pas-à-pas. Le système comporte donc un moteur pas-à-pas M1 à M5 pour chaque filtre, un dispositif de commande DC1 à DC5, pour chaque moteur et un ordinateur O ayant une interface moteur IM reliée par un bus de données b1 à b5 à chaque dispositif de commande DC1 à DC5 d'un moteur M1 à M5 et par une interface IC à un convertisseur analogique numérique CAN dont une entrée est reliée à la sortie de chaque filtre F1 à F5 par un circuit de montage en série de plusieurs éléments. Ce circuit comprend essentiellement un réseau adaptateur RA qui comporte cinq entrées E5 à E10, chacune reliée à la sortie d'un filtre F1 à F5 par l'intermédiaire d'un coupleur C1 et une seule sortie S1 reliée à une entrée d'un mélangeur ME ayant une deuxième entrée reliée à la sortie d'un synthétiseur SY dont l'entrée est reliée à l'interface ISY de l'ordinateur O. La sortie du mélangeur est connectée à l'entrée d'un amplificateur sélectif AS. La sortie de celui-ci est reliée au convertisseur CAN par l'intermédiaire d'un circuit de détection de niveau DN.

L'arrangement représenté comporte cinq bornes d'entrée de fréquence E1 à E5 chacune reliée, d'une part, à l'entrée d'un filtre F1 à F5, par l'intermédiaire d'un condensateur C2 et, d'autre part, à une entrée d'un commutateur CM, par l'intermédiaire d'un filtre passe-bas comprenant un condensateur C3 mis à la masse et une inductance montée en série L1. Ce commutateur réalisé sous forme d'un multiplexeur comporte donc cinq entrées E11 à E15 et une seule sortie S2 qui est reliée par une interface ICM à l'ordinateur O, qui comporte deux lignes 15 et 16 pour transmettre à l'ordinateur des informations concernant l'accord des filtres sur des nouvelles fréquences et pour recevoir de l'ordinateur des signaux d'alarme.

En revenant aux filtres F1 à F5, les sorties des cinq filtres sont réunies en S3 et reliées à un dispositif formant filtre de sortie et coupleur SC.

Concernant l'ordinateur O, on a schématiquement indiqué qu'il comporte une mémoire morte ROM1 ainsi que deux mémoires vives RAM1 et RAM2 dont les fonctions seront décrites plus loin. Les signes HO et BA indiquent respectivement une horloge et une batterie d'alimentation en énergie électrique. Bien entendu l'ordinateur est équipé d'une mémoire morte (non représentée) contenant l'algorithme déterminant le fonctionnement de l'ordinateur. Les signes AI1 et AI2 désignent deux sources d'alimentation en énergie de par exemple 24 V, respectivement principale et de secours, qui peuvent être reliées alternativement par un commutateur COM sous la commande de l'ordinateur symbolisée par la ligne fléchée I1 à un distributeur d'alimentation en énergie du moteur. Ce distributeur assure également l'alimentation en énergie électrique de l'ordinateur O, par une liaison I2.

Concernant le convertisseur analogique-numérique CAN il est relié par une autre entrée à un capteur de température ambiante CT. IL transmet les données à l'interface IC par une ligne indiquée en 3 et est commandée par l'ordinateur via une liaison 4.

Pour compléter la description, le réseau adaptateur dont la structure est connue en soi comporte un certain nombre de résistances, à savoir une résistance R1 reliant chaque sortie de filtre à la sortie S1 du réseau, cette dernière étant reliée à la terre par l'intermédiaire d'une résistance R2 tandis que la borne de sortie de filtre de chaque résistance R1 est reliée par une résistance R3 à la masse.

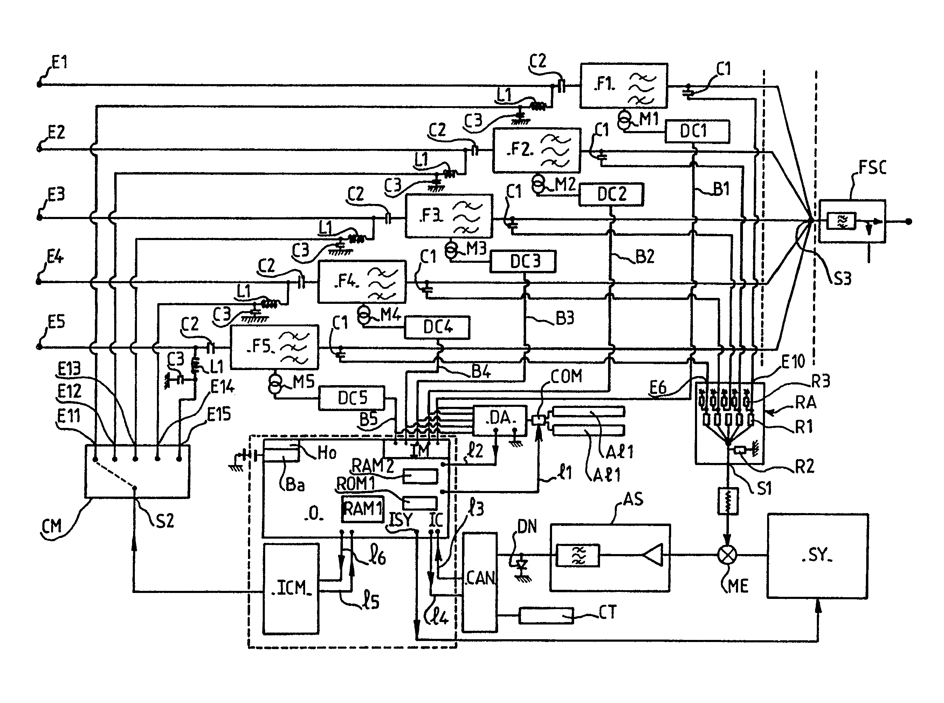

On décrira ci-après le fonctionnement de l'agencement montré à la figure 1. Cette description fera également apparaître le déroulement du procédé selon l'invention.

Pour changer la fréquence d'accord des filtres F1 à F5, on applique à une des bornes E1 des cinq voies d'entrée un signal de basse fréquence comprenant les informations de numéro de voies, et de la fréquence de la nouvelle porteuse sur laquelle la ou les filtres doivent être accordés, ainsi que le niveau de puissance de celle-ci. Dans l'exemple représenté, ce signal sera appliqué à l'entrée E1 de façon à pouvoir parvenir à travers le filtre passe-bas associé à la voie d'entrée et le commutateur multiplexeur à l'interface ICM qui transmet les informations par la liaison L5 à l'ordinateur O. Celui-ci est programmé pour pouvoir piloter à l'aide d'un algorithme les moteurs pas-à-pas M1 à M5 des filtres, de façon à positionner précisément les extrémités des axes des moteurs destinés à entraîner les plongeurs des filtres. Cet algorithme utilise un ensemble de données contenues dans des mémoires RAM et ROM et détectées aux interfaces IC en provenance du convertisseur CAN. L'ordinateur déclenchera des alarmes par la liaison L6 à l'interface ICM. L'alarme indiquera un défaut de positionnnement du système.

On expliquera ci-après les différentes opérations que l'ordinateur accomplit à l'aide de l'algorithme susmentionné pour le positionnement d'un organe mobile par exemple en forme d'un plongeur d'un filtre, dans ses nouvelles positions correspondant à une nouvelle fréquence sélectionnée. La nouvelle fréquence sélectionnée $f_s$ est appliquée au filtre à accorder. Un échantillon de ce signal de la fréquence $f_s$ parvient après le passage à travers le filtre via le réseau adaptateur RA au mélangeur ME qui reçoit à son autre entrée en provenance du synthétiseur SY un signal ayant la fréquence $f_s + f_i$, $f_i$ étant par exemple de 30 MHz pour des fréquences sélectionnables entre 935 et 960 MHz. Le signal de sortie du mélangeur est appliqué à l'amplificateur sélectif AS, adapté pour produire à sa sortie un signal de la fréquence fi et d'une amplitude qui correspond à l'amplitude du signal de sortie du signal de la fréquence sélectionnée. L'amplitude du signal fi est détectée et la valeur ainsi obtenue est transmise sous forme numérisée par le convertisseur CAN à l'ordinateur. Sous l'effet de son algorithme, l'ordinateur envoie au moteur M du filtre à accorder, des signaux de déplacement axial du plongeur du filtre, en fonction de l'amplitude mesurée du signal fi jusqu'à l'obtention de la valeur d'amplitude maximale. Pour trouver cette position du plongeur, celui-ci sera déplacé dans le sens produisant une augmentation de l'amplitude mesurée et la position recherchée se caractérisera par une variation d'amplitude égale à zéro. La deuxième phase du procédé selon l'invention a pour objectif de positionner l'organe mobile de variation de fréquence du filtre afin que la courbe caractéristique de celui-ci soit symétrique par rapport à la fréquence sélectionnée fs. A cette fin, on déplacera l'organe mobile, à partir de sa position d'amplitude maximale dans les deux sens jusqu'à ce que le signal de sortie du filtre présente la même valeur prédéterminée inférieur par exemple de 0,5db à la valeur d'amplitude maximale. Les courses ΔS1 et S2 de l'organe mobile permettent de calculer la position de l'organe mobile dans laquelle la courbe caractéristique du filtre est symétrique par rapport à la fréquence sélectionnée fs.

La position de symétrie de sortie s'obtient selon la formule suivant :

$$P_s = P_m + \frac{S1 - S2}{2}$$

$p_s$ et $p_m$ étant respectivement les positions de symétrie et d'amplitude mapximale.

Etant donné que le moteur est un moteur pas-à-pas, chaque position et chaque course peuvent être définies par un nombre de pas du moteur.

Le système selon l'invention assure également une excellente stabilité des filtres eu égard aux dérives de fréquence en fonction des variations de la température ambiante. A cette fin l'ordinateur reçoit du convertisseur CAN des informations numérisées concernant la température ambiante du système, mesurée par le capteur de température CT, de façon à pouvoir compenser un désaccord ou décalage des filtres lorsque par exemple la température mesurée diffère d'une valeur différentielle T de la température correspondant au dernier positionnement de chaque moteur. A cette fin la mémoire ROM1 contient les données spécifiant le nombre de pas ou d'incréments des moteurs et de leur sens de rotation en fonction de la température et de la fréquence. En se reportant à la mémoire ROM1, l'ordinateur est ainsi en mesure de corriger la position d'un organe mobile du filtre en envoyant au moteur un signal numérisé indiquant le nombre de pas que le moteur doit effectuer pour que le filtre soit à nouveau exactement accordé sur la fréquence sélectionnée.

La première mémoire RAM1 stocke la fréquence, la température et la date correspondant au dernier réglage et ceci pour chacun des filtres.

La deuxième mémoire RAM2 stocke pour chaque filtre, à la suite d'un balayage de la gamme de fréquence sélectionnable pouvant comprendre par exemple 126 positions de fréquence entre 935 et 960 MHz, lors d'un arrêt du fonctionnement de l'arrangement de filtre, les données suivantes telles que : fréquence, nombre de pas moteur à partir d'une position de référence du moteur, telle que par exemple la position zéro ou initiale, date, température. La présence de l'ordinateur procure donc l'avantage, lorsqu'ultérieurement un filtre doit être accordé sur une nouvelle fréquence, de pouvoir prépositionner rapidement le moteur correspondant en se reportant à la mémoire RAM2. L'utilisation ou non de la boucle de réglage qui a servi pour l'établissement des données dans le RAM2 est déterminée par la précision de réglage que l'on demande. Cette utilisation est fortement envisagée pour réaliser un réglage précis. Ceci permet d'accorder les filtres rapidement à des nouvelles fréquences à partir de données pouvant être régulièrement actualisées. L'invention permet un autoétalonnage de l'arrangement de filtre.

## Revendications

1. Procédé pour accorder sur une nouvelle fréquence sélectionnée, au moins un filtre à fréquence variable d'un arrangement de filtres dont chacun comporte un organe de variation de fréquence qui est mobile sous l'effet d'un moteur, selon lequel on déplace l'organe de variation de fréquence jusqu'à ce qu'il se trouve dans une position représentative de l'accord du filtre sur la nouvelle fréquence sélectionnée, caractérisé en ce que l'on commande le moteur à l'aide d'un dispositif ordinateur (O), établi pour chaque fréquence sélectionable dans une gamme de fréquences prédéterminées la valeur du signal de commande du moteur pour l'accord du filtre sur la nouvelle fréquence sélectionnée, à partir d'une position de référence du moteur, stocke ces données établies dans une mémoire de l'ordinateur et programme celui-ci de façon qu'il provoque pour l'accord du filtre à une des fréquences sélectionables, l'envoi au moteur du filtre du signal de commande appropriée établie sur la base de la valeur de signal stocké, associé à cette fréquence sectionnée.

2. Procédé selon la revendication 1, caractérisé en ce que l'on utilise un moteur pas-à-pas (M1-M5) pour l'entraînement de l'organe mobile et stocke les valeurs de signaux de commande sous forme des nombres des pas de moteur à effectuer jusqu'à l'accord du filtre sur la nouvelle fréquence sélectionnée, à partir d'une position de référence du moteur, telle que la position zéro ou initiale.

3. Procédé selon l'une des revendications 1 ou 2, caractérisé en ce que l'on assure la stabilité de la fréquence d'un filtre eu égard à des dérives de fréquence en fonction de la température ambiante en stockant dans une mémoire de l'ordinateur (O) des données établissant le nombre de pas du moteur associé au filtre et le sens de rotation en fonction de la température et amène l'ordinateur à corriger la position de l'organe mobile lors de la constatation d'un changement de température, avantageusement supérieur à une valeur prédéterminée, sur la base des données stockées dans ladite mémoire.

4. Procédé selon l'une des revendications précédentes, caractérisé en ce que l'on inclut l'ordinateur et le filtre dans une boucle de réglage adaptée pour effectuer un positionnement automatique de l'organe de variation de fréquence dans sa position d'accord du filtre et utilise cette boucle comme moyen de réglage fin après une phase de positionnement sur la base des valeurs stockées dans la mémoire de l'ordinateur.

5. Procédé selon la revendication 4, caractérisé en ce que, pour effectuer un réglage fin, on applique au filtre (F1-F5) un signal de la fréquence sélectionnée et, pendant une première phase, on mesure l'amplitude du signal de sortie du filtre et positionne l'organe de variation de fréquence dans la position où l'amplitude du signal est maximale, et établit pendant une seconde phase, à partir de cette position d'amplitude maximale, par mesure de l'amplitude du signal de sortie, la position centrale de l'organe pour laquelle la fréquence sélectionnée constitue la fréquence par rapport à laquelle la courbe caractéristique du filtre (F1-F5) est sensiblement symétrique.

6. Procédé selon la revendication 5, caractérisé en ce que pendant la seconde phase précitée, on déplace l'organe mobile à partir de la fréquence d'amplitude maximale dans l'un et l'autre sens jusqu'à ce que l'amplitude du signal mesurée ait chaque fois la même valeur prédéterminée et calcule à partir des courses de l'organe mobile, la position centrale précitée.

7. Système pour la mise en oeuvre du procédé selon l'une des revendications précédentes, caractérisé en ce qu'il comprend un dispositif ordinateur (O) pourvu d'une mémoire (RAM2) adaptée pour stocker pour chaque filtre pour chaque fréquence sélectionnable le nombre de pas moteur à partir d'une position de référence du moteur et d'une mémoire (ROM1) contenant les données spécifiant le nombre de pas ou d'incréments du moteur à effectuer et son sens de rotation en fonction de la température et de la fréquence, pour compenser un désaccord du filtre dû à une variation de la température ambiante du système, et des capteurs de ladite température ambiante, relié par une interface à l'ordinateur, ce dernier étant programmé pour piloter le moteur (M1 à M5) à l'aide d'un algorithme utilisant les données continues dans ces mémoires et de données en provenance des capteurs.

8. Système selon la revendication 7, caractérisé en ce que la boucle de réglage pour l'accord sur une nouvelle fréquence sélectionnée comprend un montage en série d'un mélangeur (ME) recevant à ses deux entrées respectivement le signal de sortie du filtre à accorder et le signal d'un synthétiseur dont la fréquence diffère de la nouvelle fréquence sélectionnée par une fréquence différentielle prédéterminée, d'un amplificateur sélectif accordé sur ladite fréquence différentielle, d'un détecteur d'amplitude (DN) du signal ayant la fréquence différentielle ainsi que d'un convertisseur analogique-numérique (CAN) relié à l'ordinateur (O) par un interface (IC).

9. Système selon la revendication 9, caractérisé en ce qu'il comprend un capteur de température (CT) relié au convertisseur (CAN) précité.

10. Système selon l'une des revendications 7 à 9, caractérisé en ce que, pour un arrangement de plusieurs filtres (F1 à F5), il comprend un commutateur multiplexeur (CM) ayant une entrée (E11-E15) pour la voie d'entrée (E1-E5) de chaque filtre et une sortie (SE) reliée par une interface (ICM) à l'ordinateur (O) qui est commun, chaque filtre étant sélectivement accordable à l'aide de la boucle de réglage précitée.

11. Système selon la revendication 10, caractérisé en ce que les sorties des filtres (F1-F5) sont reliées par un réseau adaptateur (RA) à l'entrée précitée du montage en série précité.

EP 0 452 212 A1

Office européen
des brevets

**RAPPORT DE RECHERCHE EUROPEENNE**

Numero de la demande

EP    91 40 0955

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0239219 (THE MARCONI COMPANY LIMITED) <br> * colonne 1, ligne 30 - colonne 4, ligne 53; figures 1-3 * | 1 | H03J7/02 |
| A | EP-A-0119561 (DEUTSCHE THOMSON-BRANDT GMBH) <br> * page 3, ligne 12 - page 7, ligne 16; figures 1-2c * | 1 | |
| A | EP-A-0109661 (DEUTSCHE THOMSON-BRANDT GMBH) <br> * page 3, ligne 1 - page 6, ligne 26; figures 1-2 * | 1 | |
| A | EP-A-0148389 (DEUTSCHE THOMSON-BRANDT GMBH) <br> * abrégé; figures 1, 2 * | 1 | |

**DOMAINES TECHNIQUES RECHERCHES (Int. Cl.5)**

H03J

Le présent rapport a été établi pour toutes les revendications.

| Lieu de la recherche | Date d'achèvement de la recherche | Examinateur |
|---|---|---|
| LA HAYE | 21 JUIN 1991 | DHONDT I.E.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)